Europäisches Patentamt

European Patent Office

Office européen des brevets

(11) Publication number: **0 102 485**
**A2**

# (12) EUROPEAN PATENT APPLICATION

(21) Application number: **83106869.7**

(51) Int. Cl.³: **G 11 C 17/00**

(22) Date of filing: **13.07.83**

(30) Priority: **09.08.82 US 406745**

(43) Date of publication of application:
**14.03.84 Bulletin 84/11**

(84) Designated Contracting States:
**DE FR GB**

(71) Applicant: **International Business Machines Corporation**
**Old Orchard Road**
**Armonk, N.Y. 10504(US)**

(72) Inventor: **Alcorn, Charles Noble**
**8425 Reflection Lane**
**Vienna Virginia 22180(US)**

(72) Inventor: **Murray, Durwood Reginald**
**9451 Lee Highway, 506**
**Fairfax Virginia 22031(US)**

(74) Representative: **Rudolph, Wolfgang**
**Schönaicher Strasse 220**
**D-7030 Böblingen(DE)**

(54) Semiconductor memory.

(57) Circuits for a static memory, particularly for a read only memory are disclosed which has two precharge current supply devices connected to each bit line ($B_j$) to enable the fast precharging of the bit line while the address inputs are down, and which sense the voltage on a dummy bit line (10) and which controls an active load to turn on, thereby quickly charging the array bit line when all of the address inputs are down and the dummy bit line is charging. When one address input goes up and the dummy bit line starts discharging, the feedback circuit controls the active load to turn off, thereby stopping the precharge current to the array bit line.

./...

FIG. 1

SEMICONDUCTOR MEMORY

The invention relates to memory circuits for static memories and more particularly for read only memories.

Field effect transistor (FET) read only memories (ROM) are typically rectilinear arrays of FET storage devices, each storage device having its source/drain path connected between a column conductor generally referred to as a bit line and a constant potential, usually ground potential. A binary bit unit of information is permanently stored by an array FET device through selectively including or deleting the gate electrode for the device either at the time of manufacture or later at the time of programming. The gate electrode may be selectively deleted either by programming the photolithographic mask for the device or at a subsequent stage by selectively severing the connection to the gate electrode by chemical or laser etching techniques. Those gate electrodes for array FET devices which remain intact, are connected to respective row conductors generally termed word lines. In operation, the bit lines are generally precharged to a predetermined voltage level and then selected word lines are biased so that those gates connected to the biased word line render their corresponding FET array devices conductive, thereby discharging the correspondingly connected bit line. The conditionally discharged state of the bit line is sensed by a sense amplifier which is connected to the bit line.

Typical prior art approaches to precharging the bit line of an FET read only memory array make use of an externally generated precharge clock pulse which is applied to the gate of an FET charging device during an interval prior to the time that the word line will be selectively biased on. Since tolerances exist in the precision with

MA 982 008

which the clocking pulse can be turned on with respect to the instant that the word line will be turned on, provision must be made so as to avoid the overlap of the precharge clock pulse with the word line enabling pulse by separating the pulses by a sufficient interval so as to guarantee that they will not overlap. This increases the overall accessing cycle time for the read only memory array. Examples of this are shown in USP 3 959 782 wherein a static FET device and a pulsed FET device serve to charge the bit line. The pulsed FET device is turned on by an externally generated precharge signal whose timing must be separated by a sufficient interval to avoid overlap with the word line enabling signal. Other patents making a similar disclosure requiring externally generated precharge clock pulses include USPs 3 942 162; 3 936 810; and 3 810 124. These precharging techniques impose an unnecessary increment to the memory cycle time for the read only memory array.

It is therefore the object of the invention to provide an improved memory or a read only memory circuit having a precharging feature which enables the ROM to dissipate less power which has a faster access time through an improved precharging technique and the memory occupies less space and is easier to design than has been required in the prior art.

These objects of the invention are accomplished by the memory circuits with self-aligned precharge technique disclosed in the characterized part of claim 1.

A precharge circuit is disclosed for a read only memory, which has two precharge current supply devices connected to each bit line to enable the fast precharging of the bit line while the address inputs are down. The invention

MA 982 008

employs a feedback circuit which senses the voltage on a dummy bit line and which controls an active load to turn on, thereby quickly charging the array bit line when all of the address inputs are down and the dummy bit line is charging. When one address input goes up and the dummy bit line starts discharging, the feedback circuit controls the active load to turn off, thereby stopping the precharge current to the array bit line.

The resultant circuit has a faster access time since the reduced size of the load device enables a downward transition at a faster rate when one of the active array devices turns on since the amount of charge conducted through the device is significantly less than would have been conducted through a corresponding load device using a ratioed logic circuit where the size of the load and active devices must be maintained in a fixed ratio. Furthermore, the above-described device has a lower power dissipation than would a corresponding ratioed logic memory circuit because of reduced size of the load devices. The only load device dissipating significant power is the dummy load device connected to the dummy bit line and there is only one such device and such line needed per array. Still further, the overall size of the resulting read only memory array is smaller because of the smaller area size of the load devices. Still further, the read only memory circuit described above is easier to design than a conventional ratioed logic read only memory circuit which is complicated by the necessity for taking into consideration the number of active devices connected to each particular bit line, that number of devices having to be correlated with the size of the load device. Such a complicated design effort is not necessary for the above-described circuit since the ratio is large between the size of the active enhancement mode array devices and the small depletion mode load device connected to the bit line. The depletion mode load device is only used to maintain the elevated potential of the bit line after it has been precharged by the active enhancement mode load device. This feature also simplifies the design of the sense amplifier connected to the bit line.

These and other objects, features and advantages of the invention will be more fully appreciated with reference to the accompanying figures.

Figure 1 is a detailed circuit schematic diagram of a first embodiment of the read only memory with self-aligned precharge feature, employing N channel FET devices.

Figure 2 is a circuit schematic diagram of a second embodiment of the invention employing complementary MOSFET devices.

Figure 3 is a circuit schematic diagram of a third embodiment of the invention employing bipolar transistor devices.

A precharge circuit is disclosed for a read only memory, which has two precharge current supply devices connected to each bit line to enable the fast precharging of the bit line while the address inputs are down. The invention employs a feedback circuit which senses the voltage on a dummy bit line and which controls an active load to turn on, thereby quickly charging the array bit line when all of the address inputs are down and the dummy bit line is charging. When one address input goes up and the dummy bit line starts discharging, the feedback

MA 982 008

**0102485**

circuit controls the active load to turn off, thereby stopping the precharge current to the array bit line.

The resultant circuit has a faster access time since the reduced size of the load device enables a downward transition at a faster rate when one of the active array devices turns on since the amount of charge conducted through the device is significantly less than would have been conducted through a corresponding load device using a ratioed logic circuit. Furthermore, the above-described device has a lower power dissipation than would a corresponding ratioed logic memory circuit because of reduced size of the load devices. The only load device dissipating significant power is the dummy load device and connected to dummy bit line and there is only one such device and such line needed per array. Still further, the overall size of the resulting read only memory array is smaller because of the smaller area size of the load devices. Still further, the read only memory circuit described above is easier to design than a conventional ratioed logic read only memory circuit which is complicated by the necessity for taking into consideration the number of active devices connected to each particular bit line, that number of devices having to be correlated with the size of the load device. Such a complicated design effort is not necessary for the above-described circuit since the ratio is large between the size of the active enhancement mode array devices and the small depletion mode load device connected to the bit line. The depletion mode load device is only used to maintain the elevated potential of the bit line after it has been precharged by the active enhancement mode load device.

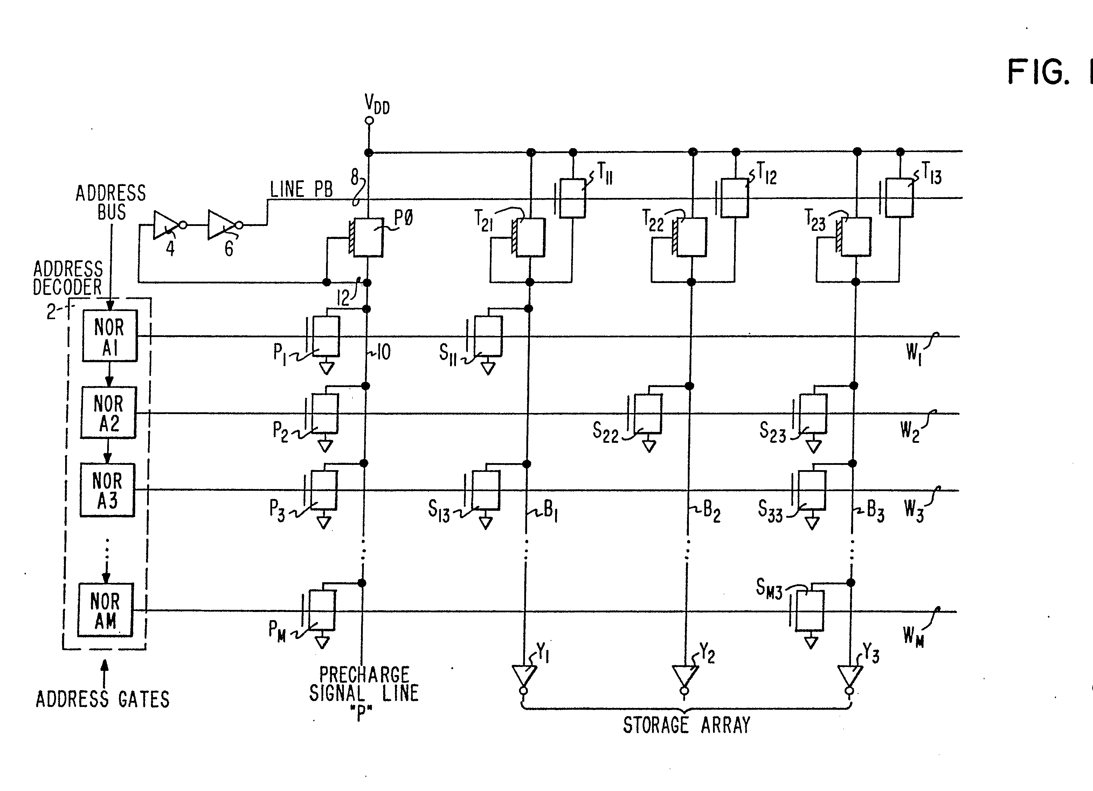

Figure 1 shows a static read only memory circuit which has a plurality of FET storage devices which are designated $S_{ij}$, where i and j are indices for standard matrix notation, i being the identity of the horizontal rows starting from the top and j being the identity of the vertical columns starting from the left. The devices are arranged into a plurality of rows and columns, with each storage device $S_{ij}$ in each column j having its gate electrode selectively connected to a respective row i word line $W_i$ in accordance with a desired storage pattern. Each storage device $S_{ij}$ and each row i has its source/drain path connected between a respective column j data bit line Bj and a first reference potential which is ground potential in this example. For example, the storage device $S_{11}$ has its source/drain path connected between the bit line $B_1$ and ground potential and its gate connected to the word line $W_1$.

The self-aligned precharge circuit in Figure 1 includes the dummy bit line 10 which is connected through the source/drain path of each of a plurality of dummy FET devices $P_1$, $P_2$, $P_3$ and etc. to the first reference potential or ground potential. Each of the dummy FET devices $P_i$ has its gate connected to a respective one of the word lines $W_i$. For example, the dummy FET device $P_1$ has its gate connected to the word line $W_1$. The dummy bit line 10 has a sensing node 12 which is connected through a dummy static FET load device $P_0$ to a second reference potential which is the drain potential $V_{dd}$. A signal developed at the sensing node 12 represents the occurrence of a signal on any of the plurality of word lines $W_i$. In the examples given herein, N channel FET devices are assumed so that a positive potential on the gate of an FET device with respect to its source will cause the FET device to go into conduction. It is under-

MA 982 008

stood of course that P channel FET devices could be alternately employed. For N channel FET devices, when a
particular word line $W_i$ goes positive, the correspond-
ing dummy FET device $P_i$ will become conductive and will
discharge the potential on the dummy bit line 10. This
drop in potential occurs at the sensing node 12 and
will be used to turn off active load devices connected
to the bit lines in the array, as will become more
apparent as the discussion proceeds.

The self-aligned precharge circuit further includes a
plurality of active bit line FET load devices $T_{1j}$, each
having its source/drain path respectively connected
between a corresponding one of the data bit lines $B_j$
and the second reference potential $V_{dd}$. For example,
the active load device $T_{11}$ has its source/drain path
connected between $V_{dd}$ and the bit line $B_1$. Each of the
active FET load devices $T_{1j}$ has its gate connected to
the sensing node 12 of the dummy bit line 10. The function of the FET active load device $T_{1j}$ is to conduct
precharge current to the corresponding data bit line $B_j$
during the interval before a word line $W_i$ goes positive,
in order to provide a low resistance path for supplying
relatively large quantities of current to the bit line
$B_j$ so as to rapidly charge it up to the precharge potential. It can be seen that it is important to turn off
the active load devices $T_{1j}$ prior to the turning on of
the storage devices $S_{ij}$, in order that any conditional
discharge which is desired for the bit line $B_j$ can be
adequately sensed by the sense amplifier $Y_j$. Thus, it
is important to terminate the conduction state of the
active FET load devices $T_{1j}$ when a signal is present on
any one of the word lines $W_i$. For example, during the
interval prior to any of the word lines $W_i$ turning on,
all of the dummy FET devices $P_i$ are in a nonconductive

MA 982 008

state and therefore the dummy load device $P_0$, which is a depletion mode FET load device, provides current to charge up and maintain in a precharged state the dummy bit line 10. The sensing node 12 applies a positive potential on the line 8 to the gates of the active FET load devices $T_{11}$, $T_{12}$ and $T_{13}$. These active FET load devices then conduct relatively large quantities of current to the respective bit lines $B_1$, $B_2$ and $B_3$ until their potentials reach the desired precharge potential.

When any one of the word lines $W_i$ turns on, for example when the word line $W_2$ starts to turn on, the dummy FET device $P_2$, whose gate is connected to the word line $W_2$, will become conductive thereby discharging the precharged state of the dummy bit line 10. This lowers the potential at the sensing node 12 which is conveyed over the line 8 to the gates of the active FET load devices $T_{11}$, $T_{12}$ and $T_{13}$, thereby turning them off. Thus, as the potential on the gates of the array storage devices $S_{22}$ and $S_{23}$ starts to rise rendering those devices conductive, the potential on their respective bit lines $B_2$ and $B_3$ will begin to drop as is desired due to the current flow through the storage devices $S_{22}$ and $S_{23}$, respectively, since there is no longer a relatively large current source in the form of the active FET devices $T_{12}$ and $T_{13}$, respectively, connected to those respective bit lines. Thus, the respective sense amplifiers $Y_2$ and $Y_3$ will sense the drop in the precharge voltage on the bit lines $B_2$ and $B_3$ and the desired output signal from the read only memory array will be achieved. The function of the self-biased depletion mode FET static load devices $T_{21}$, $T_{22}$ and $T_{23}$, whose source/drain paths are connected in the circuit for the respective bit lines $B_1$, $B_2$ and $B_3$ is for maintaining the data bit lines at the precharge potential after the active FET loads $T_{11}$, $T_{12}$ and $T_{13}$ have been respectively turned off.

MA 982 008

In this manner, the data bit lines $B_1$, $B_2$ and $B_3$ are precharged only between consecutive word line signals on the word lines $W_i$. This self-aligned feature of the precharge signal on the active FET load devices $T_{1j}$ renders unnecessary the provision of a time tolerance between the occurrence of an externally generated precharge signal and the occurrence of the word line enabling signal, and therefore a tighter sequence of timing pulses can be applied to the memory array, thereby reducing the overall cycle time for the array.

It can be seen therefore that the resultant circuit has a faster access time since the reduced size of the static FET load device $T_{21}$, for example, enables the downward transition at a faster rate when one of the active array devices $S_{11}$, for example, turns on, since the amount of charge conducted through the device $T_{21}$ is significantly less than would be conducted through a corresponding load device in a ratioed logic circuit.

Still further, there is a lower power dissipation for the read only memory array shown in Figure 1, than would be the case for corresponding ratioed logic memory circuit because of the reduced size of the static FET load devices $T_{21}$, etc. The only load device dissipating significant power is the dummy load device $P_0$ connected to the dummy bit line 10 and there is only a single dummy load device and dummy bit line needed per read only memory array.

Still further, the overall size of the read only memory array shown in Figure 1 is smaller than what would be required in the prior art because of the smaller area size of the load devices $T_{21}$, etc.

MA 982 008

Still further, the design effort involved in designing a conventional ratioed logic read only memory array circuit is complicated by the necessity for taking into consideration the number of active FET devices connected to each particular bit line and the designer must correlate the size of the load device to the number of active devices. This is no longer necessary for the FET read only memory circuit shown in Figure 1 because the ratio is large between the size of the active enhancement mode array devices $S_{11}$ or $S_{13}$, for example, and the small depletion mode load device $T_{21}$ connected to the bit line $B_1$. This is true since the load device $T_{21}$ is only used to maintain the elevated potential of the bit line $B_1$ after it has been precharged by the active FET load device $T_{11}$.

A signal amplifier can be employed in the feedback circuit between the sensing node 12 and the line 8 in order to provide an increased drive capability for larger arrays. A suitable signal amplifier can be two cascaded inverters 4 and 6, for example. However, no such signal amplifier is needed for smaller arrays.

Thus it is seen that the read only memory circuit described above generates its own precharge signal which is independent of external clocks. The self-aligned precharge signal is present only between address transitions from the address decoder 2. Generally in the prior art, dynamic precharge signals must compensate for insufficient precharging of bit lines, race conditions, clock skew and other timing difficulties. In prior art circuits, the precharge pulse width amounts to approximately one-half of the access time. In the circuit described above, the precharge signal is present only long enough

MA 982 008

to precharge the bit lines. Hence, the access time is much less than would be the case in comparable prior art read only memory designs.

In general, transitions from an address decoder 2 such as a NOR gate-type decoder, are faster from high to low potential than they are from low to high potential in order to provide a quiescent period prior to word line selection to enable the bit lines to precharge. The decoder address gates are generally designed for this criterion. The ROM circuit described herein operates best with this type of address decoder. Under address conditions, only one decoder gate generally has a high potential output, all of the other gates having low outputs. Hence, before the selection of a new address for a new word line, all of the output gates from the address decoder 2 will be initially low. When all of the address outputs are low, all of the enhancement mode dummy FET devices $P_i$ will be off. This allows the dummy load device $P_0$, which is a relatively large depletion mode FET load device, to turn fully on in a short interval and provide a high potential on the sensing node 12. As was described above, this rise in potential at the sensing node 12 is conveyed by the line 8 to the gates of the active FET load devices $T_{1j}$ in a minimum time. Later, when the dummy bit line 10 and the array bit lines $B_j$ have been precharged, and a word line has been selected with a signal input on one of the word lines $W_i$, the corresponding dummy FET device $P_i$ must quickly discharge the dimmy bit line 10. Thus it can be seen that the dummy transistors $P_i$ should be designed for a good sensitivity and quick response to the rising potential of any particular word line $W_i$.

The above-described self-aligned precharge can also be applied to FET random access memory circuits and pro-

MA 982 008

grammed logic array circuits, as well as to read only memory circuits. Although N channel FET technology has been described, it is seen that complementary MOS technology could also be employed to carry out the principles of the invention.

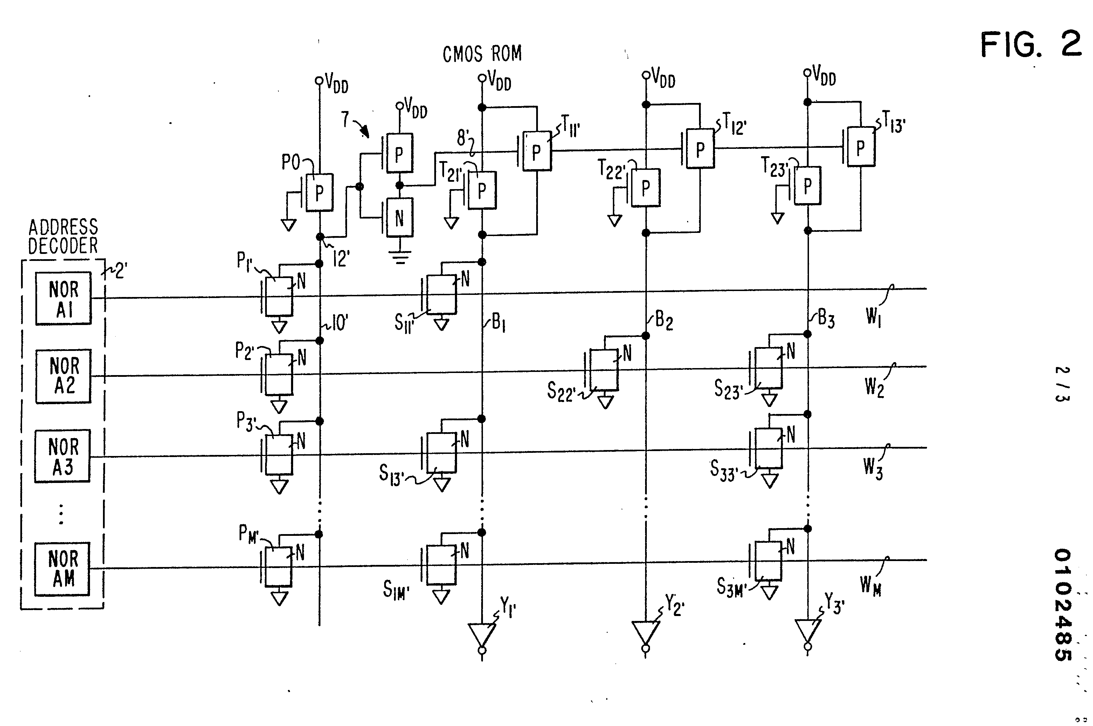

A second embodiment of the invention is shown in the circuit schematic diagram of Figure 2 wherein complementary MOS field effect transistor devices are employed. Elements in Figure 2 which correspond to similar elements in Figure 1 are designated by similar reference symbols which are primed. In Figure 2 the dummy load device $P_0'$ is a P channel FET device whose drain is connected to $V_{dd}$, whose source is connected to the sensing node 12' and whose gate is connected to ground potential. The dummy load device $P_0'$ operates in a manner similar to that described for the dummy load device $P_0$ of Figure 1. The dummy bit line 10' in Figure 2 has a plurality of dummy N channel FET devices $P_1'$ through $P_m'$ whose respective drains are connected to the dummy bit line 10', whose respective sources are connected to ground potential and whose respective gates are connected to the corresponding word lines $W_1$ through $W_m$. The dummy bit line 10' operates in the same manner as that described for the dummy bit line 10 in Figure 1.

The sensing node 12' in Figure 2 is connected to the input of a complementary MOSFET inverter 7 so that when the dummy bit line 10' is charged to its positive precharge potential, the inverter 7 will apply a correspondingly lower potential of substantially ground potential on line 8' to the gates of the respective active FET P channel load devices $T_{11}'$ through $T_{13}'$ in Figure 2, turning those load devices on so as to supply a relatively large precharge current to their corresponding

MA 982 008

connected bit lines $B_1$ through $B_3$. The active P channel FET load devices $T_{11}'$ through $T_{13}'$ in Figure 2 correspond to the active load devices $T_{11}$ through $T_{13}$ of Figure 1.

The static P channel FET load devices $T_{21}'$ through $T_{23}'$ of Figure 2 each have their gates respectively connected to ground potential so as to supply a constant, small magnitude current from the drain potential $V_{dd}$ to their respectively connected bit lines $B_1$ through $B_3$ in Figure 2. The static load devices $T_{21}'$ through $T_{23}'$ of Figure 2 correspond to the static load devices $T_{21}$ through $T_{23}$ of Figure 1. The static load devices in Figure 2 operate in a similar manner as those described in Figure 1, supplying a small quantity of current to their respectively connected bit lines $B_1$ through $B_3$ in order to maintain the precharge potential which has been achieved on the respective bit lines.

The FET array devices in Figure 2 are N channel FET devices $S_{ij}'$ which correspond to the array FET devices $S_{ij}$ of Figure 1. The sense amplifiers $Y_j'$ of Figure 2 correspond to the sense amplifiers $Y_j$ of Figure 1. The overall operation of the CMOS embodiment of the invention shown in Figure 2 is similar to that for the invention embodied in N channel FET devices shown in Figure 1. The dummy bit line 10' in Figure 2 serves to provide a self-aligned precharge feature so that when any of the word lines $W_i$ goes positive, the resultant discharge of the dummy bit line 10' will result in the turning off of the active P channel FET load devices $T_{11}'$ to $T_{13}'$, in a manner similar to that described for the operation of the circuit in Figure 1.

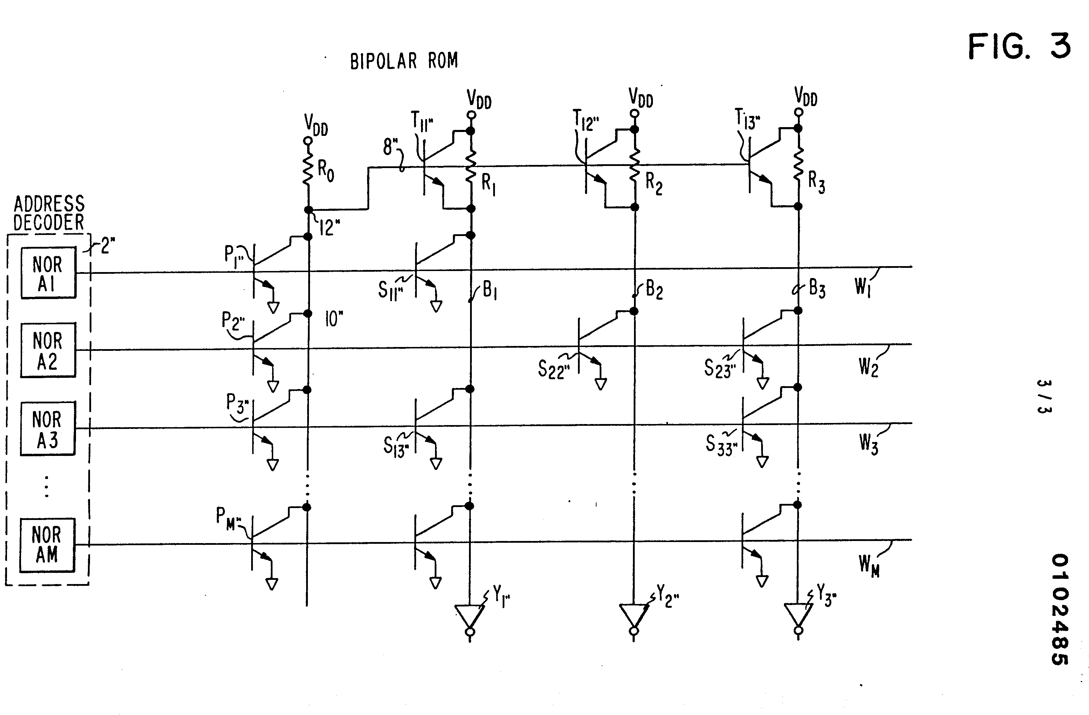

Figure 3 illustrates a third embodiment of the invention wherein NPN bipolar transistors are employed. Elements

MA 982 008

in the circuit of Figure 3 which are similar to corresponding elements in the FET embodiment of Figure 1, have similar reference numbers which are double primed. A resistive load device $R_0$, which can be a diffused or ion implanted resistor, is connected between the positive potential $V_{dd}$ and the sensing node 12''. The dummy bit line 10'' is connected to the sensing node 12'' and has a plurality of dummy NPN transistor devices $P_1$'' through $P_m$'' whose respective collectors are connected to the dummy bit line 10'', whose emitters are connected to ground potential, and whose bases are connected to corresponding word lines $W_1$ through $W_m$. The sensing node 12'' is connected by means of the line 8'' to the respective bases of the active NPN transistor loads $T_{11}$'' through $T_{13}$'' in Figure 3. The active loads $T_{11}$'' through $T_{13}$'' of Figure 3 correspond to the active FET load devices $T_{11}$ through $T_{13}$ of Figure 1. When all of the word lines $W_1$ through $W_m$ have a low potential, all of the dummy NPN transistors $P_1$'' through $P_m$'' are off and thus the dummy bit line 10'' and its sensing node 12'' rise in potential and turn on the respective active NPN load devices $T_{11}$'' through $T_{13}$'', thereby supplying precharging current to the bit lines $B_1$ through $B_3$. When any one of the word lines $W_1$ through $W_m$ goes high, the corresponding NPN dummy transistor $P_i$'' turns on thereby discharging the dummy bit line 10''. The reduction in potential at the sensing node 12'' is conveyed by the conductor 8'' to the bases of the respective active NPN loads $T_{11}$'' through $T_{13}$'', thereby turning them off. Any NPN array transistor device $S_{ij}$'' whose base is connected to the word line $W_i$ having the higher potential, is turned on, thereby discharging its corresponding bit line $B_j$ which is sensed by the connected sense amplifier $Y_j$''. The corresponding load resistor $R_1$ through $R_3$ shown in Figure 3 connected to the respective bit line $B_1$

through $B_3$ will maintain its connected bit line at the precharge potential by means of conducting a small quantity of current thereto, until that bit line has been discharged by one of the NPN array transistor devices connected to it. The resistors $R_j$ in Figure 3 correspond to the static FET load devices $T_{2j}$ of Figure 1. The overall operation of the circuit shown in Figure 3 is similar to that shown in Figure 1.

Although a specific embodiment of the invention has been disclosed, it will be understood by those of skill in the art that the foregoing and other changes in form and details may be made therein without departing from the spirit and the scope of the invention. For example, the self-aligned precharge feature can also be applied to random access memories to substitute for externally supplied timing signals.

MA 982 008

PATENT CLAIMS

1.  In a static memory circuit (Fig. 1) having a plurality of FET storage devices ($S_{ij}$) arranged into a plurality of rows and columns, with each storage device in each column having its gate selectively connected to a respective row's word line ($W_i$) in accordance with a desired storage pattern and each storage device in each row having its source/drain path connected between a respective column's data bit line ($B_j$) and a first reference potential, a self-aligned precharge circuit which is characterized by

a dummy bit line (10) connected through the source/drain path of each of a plurality of dummy FET devices to said first reference potential (ground), each said dummy FET device ($P_i$) having its gate connected to a respective one of said word lines ($W_i$), having a sensing node (12) connected through a dummy static load device ($P_0$) to a second reference potential ($V_{dd}$), for sensing at said sensing node the occurrence of a signal on any of said plurality of word lines ($W_i$),

a plurality of active bit line FET load devices ($T_{ij}$), each having its source/drain path respectively connected between a corresponding one of said data bit lines and a second reference potential and having its gate connected to said sensing node of said dummy bit line, for conducting precharge current to said corresponding data bit lines in the absence of said signal on any of said word lines and terminating the conduction of said pre-

MA 982 008

charge current when said signal is present on any one of said word lines,

a plurality of static bit line load devices ($T_{2j}$), each respectively connected between a corresponding one of said data bit lines and said second reference potential, for maintaining said data bit lines at a precharged potential after said active FET loads are turned off;

whereby the data bit lines ($B_j$) are precharged only between consecutive word line signals.

2.  The circuit of claim 1, wherein said FET devices ($S_{ij}$) are N channel FET devices.

3.  The circuit of claim 2, wherein said dummy static load device ($P_i$) is an N channel, depletion mode FET load device.

4.  The circuit of claim 3, wherein each of said plurality of dummy FET devices ($P_i$) is an N channel, enhancement mode FET device.

5.  The circuit of claim 2, characterized in that the plurality of active bit line FET load devices is an N channel, enhancement mode FET device.

6.  The circuit of claim 5, characterized in that the plurality of static bit line load devices is an N channel, depletion mode FET load device.

7.  The circuit of claim 6, characterized in that the dummy static load device is an N channel, depletion mode FET load device.

8. The circuit of claim 7, characterized in that each of said plurality of dummy FET devices is an N channel, enhancement mode FET device.

9. The circuit of claim 8, characterized in that the plurality of FET storage devices is an N channel, enhancement mode FET device.

10. The circuit of claim 1, characterized in that FET devices are P channel FET devices.

11. In a read only memory circuit having a plurality of N channel FET storage devices arranged into a plurality of rows and columns, with each storage device in each column having its gate selectively connected to a respective row's word line in accordance with a desired storage pattern and each storage device in each row having its source/drain path connected between a respective column's data bit line and a first reference potential, a self-aligned precharge circuit, characterized by

a dummy bit line connected through the source/drain path of each of a plurality of dummy N channel FET devices to said first reference potential, each said dummy FET device having its gate connected to a respective one of said word lines, having a sensing node connected through a dummy P channel FET static load device to a second reference potential, for sensing at said sensing node the occurrence of a signal on any of said plurality of word lines;

a plurality of active bit line P channel FET load devices, each having its source/drain path respectively connected between a corresponding one of said data

MA 982 008

bit lines and said second reference potential and having its gate connected to said sensing node of said dummy bit line, for conducting precharge current to said corresponding data bit lines in the absence of said signal on any of said word lines and terminating the conduction of said precharge current when said signal is present on any one of said word lines;

a plurality of static P channel FET bit line load devices, each respectively connected between a corresponding one of said data bit lines and said second reference potential, for maintaining said data bit lines at a precharged potential after said active FET loads are turned off;

whereby the data bit lines are precharged only between consecutive word line signals.

12. In a read only memory circuit having a plurality of NPN bipolar transistor storage devices arranged into a plurality of rows and columns, with each storage device in each column having its base selectively connected to a respective row's word line in accordance with a desired storage pattern and each storage device in each row having its emitter-collector path connected between a respective column's data bit line and a first reference potential, a self-aligned precharge circuit, characterized by

a dummy bit line connected through the emitter-collector path of each of a plurality of dummy NPN bipolar transistor devices to said first reference potential, each said dummy transistor device having

MA 982 008

its gate connected to a respective one of said word lines, having a sensing node connected through a dummy load device to a second reference potential, for sensing at said sensing node the occurrence of a signal on any of said plurality of word lines;

a plurality of active bit line NPN bipolar transistor load devices, each having its emitter-collector path respectively connected between a corresponding one of said data bit lines and said second reference potential and having its base connected to said sensing node of said dummy bit line, for conducting precharge current to said corresponding data bit lines in the absence of said signal on any of said word lines and terminating the conduction of said precharge current when said signal is present on any one of said word lines;

a plurality of bit line load devices, each respectively connected between a corresponding one of said data bit lines and said second reference potential, for maintaining said data bit lines at a precharged potential after said active transistor loads are turned off;

whereby the data bit lines are precharged only between consecutive word line signals.

FIG. 1

# FIG. 2

CMOS ROM

ADDRESS DECODER

NOR A1   NOR A2   NOR A3   ...   NOR AM

$W_1$   $W_2$   $W_3$   $W_M$

$B_1$   $B_2$   $B_3$

$Y_1'$   $Y_2'$   $Y_3'$

$T_{11'}$   $T_{12'}$   $T_{13'}$

$T_{21'}$   $T_{22'}$   $T_{23'}$

$S_{11'}$   $S_{13'}$   $S_{1M'}$

$S_{22'}$

$S_{23'}$   $S_{33'}$   $S_{3M'}$

$P_0$   $P_1'$   $P_2'$   $P_3'$   $P_M'$

$V_{DD}$

$I_0'$   $I_2'$

7   8'   2'

M–MA 982 008

ADDRESS DECODER

BIPOLAR ROM

FIG. 3

0102485